Europäisches Patentamt

European Patent Office

Office européen des brevets

(11) Veröffentlichungsnummer: **0 248 310 B1**

(12) **EUROPÄISCHE PATENTSCHRIFT**

(45) Veröffentlichungstag der Patentschrift: 25.09.91

(51) Int. Cl.⁵: **B05D 7/14**, B32B 31/12, B32B 15/08

(21) Anmeldenummer: 87107580.0

(22) Anmeldetag: 25.05.87

(54) **Verfahren zur Herstellung eines Metall-Kunststoff-Laminates.**

(30) Priorität: 06.06.86 DE 3619032

(43) Veröffentlichungstag der Anmeldung:
09.12.87 Patentblatt 87/50

(45) Bekanntmachung des Hinweises auf die
Patenterteilung:
25.09.91 Patentblatt 91/39

(84) Benannte Vertragsstaaten:
DE FR GB IT

(56) Entgegenhaltungen:
EP-A- 0 223 531
CH-A- 634 789
FR-A- 2 086 447
GB-A- 945 261

(73) Patentinhaber: BAYER AG

W-5090 Leverkusen 1 Bayerwerk(DE)

(72) Erfinder: Wank, Joachim, Dipl.-Ing.
Zülpicher Strasse 7
W-4047 Dormagen(DE)
Erfinder: Burkhardt, Claus, Dr,
Hasenheide 12
W-4150 Krefeld(DE)
Erfinder: Schmoranzer, Hans-Wolfgang,
Dipl.-Ing.
Bengdbruchstrasse 14
W-4156 Willich 4(DE)

## Beschreibung

Die Erfindung betrifft ein Verfahren zur Herstellung eines Metall-Kunststoff-Laminates unter Verwendung von Polyurethan-Haftschichten.

Metall-Kunststoff-Laminate werden zur Zeit hergestellt, indem man die Metallteile mit entsprechendem Kunststoffmaterial umspritzt bzw. beschichtet.

Zur Verbesserung der Haftung zwischen Metall- und Kunststoffkörper werden die Metallteile im Bereich der Kunststoffummantelung geprägt, durchbrochen, mäanderförmig geformt, etc. Durch diese Art der mechanischen Veränderung kann man zwar eine hohe Beanspruchbarkeit gegen mechanische Zugbelastung erreichen, jedoch wird hierdurch kein feuchtigkeitsdichter bzw. druckfester Verbund erreicht, da durch den unterschiedlichen Ausdehnungskoeffizienten zwischen Metall- und Kunststoff, Haarrisse beim Abkühlungsprozess auftreten. Für Anwendungen, bei denen die Forderung nach Dampf- und Druckfestigkeit zwingend erforderlich ist, wurden zahllose Versuche durchgeführt, um dieses Ziel zu erreichen. Bei bisherigen Lösungen hatte man, nach der Ummantelung bzw. Beschichtung der Metallteile, auf der Innen- und Außenseite der Gehäuse im Bereich der Metallkontakte Harzsysteme aufgebracht, die eine Oberflächenadhäsion sowohl zum Metall als auch zum Kunststoff hatten.

Da es sich hierbei meist um sehr dünne Schichten handelt, hatten diese den Nachteil, daß sie bei mechanischer Beanspruchung Haarrisse bekamen und damit ihre Aufgabe nicht mehr erfüllten.

Es hat daher nicht an Versuchen gefehlt, im Bereich der Ummantelung zwischen Kunststoff und Metall einen Verbund zu erreichen, der die Anforderung hinsichtlich Dampf- und Druckfestigkeit erfüllt. Die bisher bekannte Möglichkeit, dieses Ziel bei einigen wenigen Metall-Kunststoff-Kombinationen zu erreichen, besteht in der Verwendung von Epoxidharzen als Haftvermittler zwischen Metall und Kunststoff. Die Beschränkung auf nur wenige Kunststoffe ist dadurch gegeben, daß Epoxidharze nur zu wenigen Kunststoffmaterialien eine Verbindung eingehen, sehr spröde sind und sich außerdem schwierig verarbeiten lassen, da es sich um ein 2-Komponenten-System handelt.

Aus der DE-A-25 17 032 sind zwar Verbundfolien mit Polyurethanhaftvermittlern bekannt, jedoch wird hier keine Metall-Kunststoff-Verklebung angegeben.

In der CH-PS 634789 wird eine Verklebung zwischen einer Metallfolie und einer vorgebildeten Kunststoffolie, z.B. einer biaxil orientierten Kunststoffolie unter Verwendung eines Kunstharzklebers, z.B. einem typischen Polyurethanklebstoff, beschrieben.

Die bekannten Verfahren zur Herstellung eines Metall-Kunststoff-Laminates sind aufwendig und nicht zufriedenstellend.

Der Erfindung lag deshalb die Aufgabe zugrunde Metall-Kunststoff-Verbundsysteme auf einfache Weise herzustellen.

Gegenstand der Erfindung ist ein Verfahren zur Herstellung eines Metall-Kunststoff-Laminates, dadurch gekennzeichnet, daß man ein Metallteil mit einem Polyurethan in gelöster oder dispergierter Form beschichtet, die flüssige Phase abzieht und das so erhaltene PU-beschichtete Teil mit der Schmelze eines thermoplastischen Kunststoffes im Extrusionsbeschichtungsverfahren beschichtet.

In einer besonders bevorzugten Ausführungsform handelt es sich bei dem Metallteil um eine Folie, die insbesondere eine Stärke von 0,01 bis 0,5 mm hat. Die PU-Schicht weist Trockenfilmstärken von 1 bis 80 $\mu$m, vorzugsweise von 10 bis 30 $\mu$m auf.

Erfindungsgemäß kann das Metallteil des erhaltenen Metall-Kunststoff-Laminates nach üblichen Verfahrensweisen und nach vorgegebenen Mustern partiell abgeätzt werden unter Erhalt einer elektrischen Schaltung und anschließend gegebenenfalls dreidimensional verformt werden. Das so erhaltene Teil kann mit einem weiteren thermoplastischen Kunststoff auf der freien Kunststoffoberfläche hinterspritzt werden.

Die Herstellung der erfindungsgemäß zu verwendenden Metallteile erfolgt vorzugsweise in Form von Metallfolien. Diese werden vorzugsweise hergestellt durch Kalt- und Warmwalzen der entsprechenden Metallbleche oder, speziell bei Kupferfolien, durch kontinuierliche elektrolytische Abscheidung von Kupfer-II-Lösungen auf einem als Kathode geschalteten korrosionsfesten endlosen Stahlband, das in das Bad aus Kupfer-II-Lösung eintaucht, sich darin in einer Richtung kontinuierlich bewegt. Die durch die elektrolytische Abscheidung auf dem Stahlband gebildete dünne Kupferschicht wird an einem Wendepunkt des Stahlbandes abgezogen.

Zur Herstellung der erfindungsgemäß geeigneten Polyurethanschichten können sowohl wäßrige, zu transparenten Filmen auftrocknende Dispersionen von vorzugsweise linearen Polyesterpolyurethanen, welche COOH und/oder Sulfonsäuregruppen besitzen, als auch als zu transparenten Filmen auftrocknende organische Lösungen von vorzugsweise linearen Polyesterpolyurethanen, die gegebenenfalls ein höherfunktionelles Polyisocyanat als Vernetzer enthalten, verwendet werden. Geeignete Polyurethandispersionen sind beispielsweise solche auf Basis von linearen Polyesterdiolen, aromatischen oder aliphatischen Diisocyanaten und gegebenenfalls den üblichen Kettenverlängerungsmitteln, die unter Mitverwendung von ionischen Aufbaukomponenten entsprechend der US-A-34 79 310 oder der DE-A-14 95 847 hergestellt worden sind. Sehr gut geeignet sind auch die wäßrigen Dispersionen von Carboxylat- und Sulfonatgruppen aufweisenden, vorzugsweise linearen Polyesterpolyurethanen, wie sie gemäß DE-A-28 04 609 erhalten werden können. Im Falle der Verwendung von organischen Lösungen von vorzugsweise linearen Polyesterpolyurethanen kommen vorzugsweise Lösungen von nicht-ionischen linearen Polyesterpolyurethanen in geeigneten Lösungsmitteln in Betracht. Bei diesen Polyurethan handelt es sich vorzugsweise um Umsetzungsprodukte von (i) Diisocyanaten wie 2,4- und/oder 2,6-Diisocyanatotoluol, 4,4'-Diisocyanatodiphenylmethan, Hexamethylendiisocyanat, Isophorondiisocyanat oder 1,5-Diisocyanatonaphthalin oder deren Gemischen mit (ii) Polyesterdiolen des Molekulargewichtsbereichs ($\overline{M}w$) 1000 bis 5000, vorzugsweise 1500 bis 4000, insbesondere auf Basis von Adipinsäure und/oder Phthalsäure und geeigneten Alkylendiolen wie Ethylenglykol, 1,4-Butandiol, 1,6-Hexandiol und/oder deren Gemischen und gegebenenfalls (iii) Kettenverlängerungsmitteln, beispielsweise den zuletztgenannten Diolen, wobei die Reaktionspartner unter Einhaltung eines NCO/OH-Äquivalentverhältnisses von 0,9:1 bis 1:1,1, vorzugsweise 0,95:1 bis 1:1, zum Einsatz gelangen, und wobei pro Mol Polyesterdiol gegebenenfalls 0,1 bis 0,2 Mol Kettenverlängerer bzw. Kettenverlängerergemisch zum Einsatz gelangen. Geeignete Lösungsmittel für derartige Polyesterpolyurethane sind beispielsweise Ethylacetat, Butylacetat, Methylethylketon, Methylisobutylketon oder aus derartigen Lösungsmitteln bestehende Gemische. Die Dispersionen oder Lösungen werden im allgemeinen mit einem Feststoffgehalt von 10 - 40 Gew.-% verwendet. Oft kann es zweckmäßig sein, den genannten Lösungen untergeordnete Mengen eines höherfunktionellen Polyisocyanats, beispielsweise an Tris-(6-isocyanatohexyl)-biuret einzuverleiben, um die mechanischen Eigenschaften des letztendlich erhaltenen Polyurethanfilms zu verbessern.

Ebenfalls geeignete Polyurethansysteme sind Umsetzungsprodukte von Polyethern mit Diisocyanaten, wobei ein bevorzugter Polyether Polypropylenoxid ist, und diese Polyether in bekannter Weise mit den vorher genannten Diisocyanaten umgesetzt werden, und die Umsetzung so erfolgt, daß entweder Polyurethane mit einem freien NCO-Gehalt von 0,5 bis 10 Gew.-%, bevorzugt 0,5 bis 5 Gew.-% oder Polyurethane mit einem freien OH-Gehalt von 0,5 bis 15 Gew.-%, bevorzugt 0,5 bis 5 Gew.-%, erhalten werden.

Die beschriebenen Polyurethankleber können zur Erhöhung der Temperaturbeständigkeit ausgehärtet werden.

Hierzu werden die auf Seite 2 genannten Polyurethankleber mit Diolen oder aminhaltigen Epoxidharzen und die auf Seite 3 genannten Polyurethankleber mit Isocyanaten, vorzugsweise Triisocyanaten, in bekannter Weise umgesetzt. Als Triisocyanate sind beispielsweise die durch Umsetzung von 1 Mol Trimethylolpropan mit 3 Mol des Isomerengemisches aus 2,4- bzw. 2,6-Diisocyanatotoluol erhältlichen oder Biuretpolyisocyanate des Hexamethylendiisocyanats geeignet.

Besonders geeignete Polyurethane sind ein Polyurethandispersions-System auf Basis eines linearen Polyesterurethans, vorzugsweise auf Basis von Polyalkylenadipinat oder Polyalkylenphthalat, mit einem Molekulargewicht von 1000 bis 8000, vorzugsweise von etwa 2000, und einem Diisocyanat, vorzugsweise Toluylendiisocyanat oder Hexamethylendiisocyanat und Kettenverlängerung mit Sulfonsäure-oder Carbonsäure-haltigen Diaminen, gegebenenfalls im Gemisch mit aliphatischen Diaminen. Weitere Polyurethankomponenten sind Polyurethanlösungen auf Basis Polyalkylenadipinaten, vorzugsweise Polybutylenadipinat oder Polybutylen/Polyhexamethylenmischadipinat, mit einem Molekulargewicht von 1000 bis 8000 und Hexamethylendiisocyanat, gegebenenfalls in Mischung mit Isophorondiisocyanat im Verhältnis von 1 bis 99 : 99 bis 1, und gegebenenfalls Diol-Kettenverlängerungsmitteln und/oder Isophorondiamin. Weiter bevorzugte Polyurethane sind vorzugsweise OH-Endgruppen aufweisende Polyesterurethanlösungen, die mit Triisocyanaten versetzt werden. Andere bevorzugte Polyurethanlösungen sind solche, bei denen Polyetherurethanlösungen mit endständigen NCO-Gruppen verwendet werden, die mit aminhaltigen Kettenverlängerungsmitteln umgesetzt worden sind.

Die PU-Schicht kann kontinuierlich entweder im Rollcoateroder Rakelverfahren, im Vorhanggießverfahren oder im Airless-Sprühverfahren auf die Metallfolie aufgebracht werden. Die Menge der Dispersion bzw. Lösung wird so bemessen, daß Trockenfilmstärken von 1 - 80 $\mu$m, vorzugsweise 10 - 30 $\mu$m, resultieren.

Erfindungsgemäß zu verwendende Kunststoffe sind insbesondere Thermoplasten, besonders solche aus bekannten thermoplastischen aromatischen Polycarbonaten mit Gewichtsmittelmolekulargewichten $\overline{M}w$ von 25 000 bis 200 000, vorzugsweise von 30 000 bis 120 000 und insbesondere von 30 000 bis 80 000 ($\overline{M}w$ ermittelt über $\eta_{rel}$ in $CH_2Cl_2$ bei 20° C und einer Konzentration von 0,5 g pro 100 ml); erfindungsgemäß geeignete thermoplastische Kunststoffe sind außerdem vorzugsweise solche aus bekannten, thermoplastischen Polyarylsulfonen, welche linear (siehe DE-OS 27 35 144) oder verzweigt (siehe DE-OS 27 35 092 bzw. DE-OS 23 05 513) sein können.

Geeignete lineare Polyarylsulfone sind alle bekannten aromatischen Polysulfone oder Polyethersulfone mit $\overline{M}w$ (Gewichtsmittelmolekulargewicht gemessen beispielsweise mittels Lichtstreuung) zwischen etwa 15 000 und etwa 55 000, vorzugsweise zwischen etwa 20 000 und etwa 40 000. Derartige Polyarylsulfone sind beispielsweise in DE-A-17 19 244 bzw. US-A-33 65 517 beschrieben.

Geeignete verzweigte Polyarylsulfone sind insbesondere die verzweigten Polyarylethersulfone gemäß DE-A-23 05 413 bzw. US-A-39 60 815, deren $\overline{M}w$ (Gewichtsmittelmolekulargewicht, gemessen beispielsweise mittels Lichtstreuung) zwischen etwa 15 000 und etwa 50 000, vorzugsweise zwischen etwa 20 000 und 40 000 liegen.

Geeignete thermoplastische Kunststoffe sind vorzugsweise auch thermoplastische Celluloseester, thermoplastische Polyvinylchloride, thermoplastische Styrol-Acrylnitiril-Copolymerisate, Polyolefine, Polyamide, Polyalkylen- und Polyarylenterephthalate, Polyphosphonate und Polyphenylsulfid. Erfindungsgemäß geeignete Celluloseester werden nach üblichen Verfahren durch Veresterung dar Cellulose mit aliphatischen Monocarbonsäureanhydriden, vorzugsweise Essigsaure- und Buttersäure- oder Essigsäure- und Propionsäureanhydrid, gewonnen. Die in der Rohlosung durchzuführende Hydrolyse wird durch einen geringen Wasserüberschuß so gesteuert, daß ein geringer Hydroxylgehalt (4 bis 25) erhalten wird. Die oxidative Bleiche des aus der Lösung isolierten Celluloseesters muß so durchgeführt werden, daß im Endprodukt kein Oxidationsmittel mehr nachweisbar ist; gegebenenfalls muß eine Nachbehandlung mit Reduktionsmitteln erfolgen. Zur Bestimmung der OH-Zahl werden die freien Hydroxylgruppen des Celluloseeters mit Acetanhydrid in Pyridin verestert, der Überschnuß Anhydrid mit Wasser umgesetzt und zurücktitriert (Vorschrift: C.J.Mahn, L.B.Genung und R.F.Williams, Analysis of Cellulose Derivatives, Industrial and Engineering Chemistry, Vol. 14, Nr. 12, 935-940 (1942)).

Die Viskosität der Celluloseester soll 0,3 bis 0,5 Poise, gemessen als 20 gew.-%ige Lösung in Aceton, betragen. Vorzugsweise zu verwendende Celluloseester weisen im Falle der Acetobutyrate einen Essigsäuregehalt von 17 bis 23 Gew.-% und einen Buttersäuregehalt von 45 bis 50 Gew.-%, im Falle der Acetopropionate einen Propionsäuregehalt von 61 bis 69 Gew.-% und einen Essigsäuregehalt von 2 bis 7 Gew.-% auf. Die OH-Zahlen liegen üblicherweise zwischen 4 und 25. Die mittleren Gewichtsmittel der Molekulargewichte $\overline{M}w$ liegen zwischen 10 000 und 1 000 000, vorzugsweise zwischen 100 000 und 500 000.

Erfindungsgemäß geeignete thermoplastische Polyvinylchloride sind beispielsweise die im Handel befindlichen PVC-Typen.

Erfindungsgemäß geeignete thermoplastische Styrol-Acrylnitril-Copolymerisate sind Mischpolymerisate des Styrols mit vorzugsweise Acrylnitril die z.B. durch Suspensionspolymerisation in Gegenwart von Katalysatoren aus den Monomeren bzw. der Mischung der Monomeren mit $\overline{M}w$ von 10 000 bis 600 000 erhalten werden ($\overline{M}w$ gemessen in DMF bei C = 5 g/l und 20° C). Literatur dazu siehe Beilsteins Handbuch der Organischen Chemie, 4. Auflage, 3, Ergänzungswerk, B 1.5, Seiten 1163-1169, Springer Verlag 1964, H.Ohlinger, Polystyrol 1. Teil, Herstellungsverfahren und Eigenschaften der Produkte, Springer Verlag (1955).

Das Aufbringen des Kunststoffes auf den mit dem Polyurethan beschichteten Metallkörper, insbesondere die Metallfolie, geschieht in bekannter Weise im Extrusionsbeschichtungsverfahren.

Hierbei läuft eine mit dem Polyurethan beschichtete Metallfolie so in den Walzenspalt einer Kaschierstation, daß sie mit der Schmelze des thermoplastischen Kunststoffes, die aus einer Düse ausgetragen wird, die senkrecht zum Walzenspalt angeordnet ist, in Kontakt kommt.

In dem Augenblick, wo die Kunststoffschmelze mit der Polyurethanschicht in Kontakt kommt, entsteht eine innige Verbundhaftung zwischen den Komponenten.

Die Dicke der thermoplastischen Kunststoffschicht richtet sich nach dem Verhältnis der Abzugsgeschwindigkeit des Laminates der Komponenten und der Menge der pro Zeiteinheit angepreßten Schmelze des thermoplastischen Kunststoffes.

Dieser Verbund läßt sich durch Tiefziehen zu dreidimensionalen Gebilden veformen, die z.B. als Abschirmmantel für elektromagnetische Wellen in elektrischen und elektronischen Geräten eingesetzt werden können.

Große Bedeutung haben die aus diesem Verbund hergestellten gedruckten Verdrahtungen, die in bekannter Weise durch partielles Abätzen der Metallfolie hergestellt werden.

Die so hergestellten Verdrahtungen lassen sich ebenfalls dreidimensional verformen, wobei eine Delamination der Komponenten durch die extrem hohe Verbundhaftung nicht auftritt.

Der Verbund kann desweiteren im Spritzgießverfahren mit weiterem thermoplastischem Kunststoff hinterspritzt werden. Zu diesem Zweck wird der zwei- oder dreidimensional geformte Verbund in ein Spritzgießwerkung eingelegt und der weitere thermoplastische Kunststoff auf die freie Oberfläche der thermoplastischen Kunststoffolie partiell oder vollflächig aufgespritzt.

Die zweite thermoplastische Kunststoffschicht ist vorzugsweise aus thermoplastischem Polymethylmethacrylat, thermoplastischen Acrylnitril-Butadien-Styrol-Copolymerisaten, thermoplastischem Polystyrol, thermoplastischem Polycarbonat, thermoplastischen Styrol-Acrylnitril-Copolymerisaten, thermoplastischen Celluloseestern, thermoplastischem Polyarylsulfon, Polyvinylchlorid, Polyamid, thermoplastischen, aliphatischen Polyestern, aromatischen Polyestern, thermoplastischem Polycarbonat, thermoplastischem Polyphenylensulfid, thermoplastischem Polyphenylenoxid, thermoplastischem Polyetheresterketon oder anderen, bekanntgewordenen, thermoplastischen Polymeren oder Copolymeren, sie können aber auch identisch mit dem über die PU-Schicht verbundenen Kunststoff sein.

Thermoplastische Polymethylmethacrylate sind beispielsweise die im Handel befindlichen Plexiglas-Typen.

Thermoplastische Acrylnitril-Butadien-Styrol-Copolymerisate sind insbesondere Mischungen aus

a) 50 bis 70 Gew.-% eines oder mehrerer Pfropfprodukte und

b) 95 bis 30 Gew.-% eines oder mehrere thermoplastischer Harze.

Pfropfprodukte (a) sind bevorzugt Polymerisate, die durch Polymerisation von Pfropfmonomeren in Anwesenheit eines Kautschuks als Pfropfbasis erhalten werden. Der Kautschukanteil ist bevorzugt 5 bis 80 Gew.-%, er hängt auch vom Polymerisationsverfahren ab.

Als Pfropfbasis kommt insbesondere Polybutadien, Naturkautschuk, Butadien/Acrylnitril-Copolymerisat und Butadien-Styrol-Co- und Blockpolymerisat in Betracht. Verwendbar sind auch Acrylester-Vinylether-Polymerisate sowie EPDM-Terpolymerisate. Pfropfmonomere sind hauptsächlich Styrolgemische aus Styrol und Acrylnitril, bevorzugt im Gewichtsverhältnis 90:10 und 50:50, Gemische aus Styrol und Methyl(meth)acrylat, bevorzugt im Gewichtsverhältnis 5:95 bis 95:5 sowie Styrol/Acrylnitril/Methyl(meth)acrylat-Gemische.

Die Herstellung solcher Pfropfprodukte ist an sich bekannt. Man kann die Pfropfmonomeren in Gegenwart eines Kautschuklatex in Emulsion polymerisieren. Die Pfropfreaktion wird dann mit einem radikalischen Initiator gestartet. Ist der Kautschuk unvernetzt und werden bei der Pfropfreaktion bestimmte Mengenverhältnisse von Pfropfmonomeren und Pfropfgrundlagen eingehalten, so ist die Größe der Kautschukteilchen im Latex bestimmend für die Teilchengröße des resultierenden Pfropfpolymerisats. Die Pfropfhülle aus chemisch an die Kautschukteilchen gebundenen Ketten des Polymerisats der Pfropfmonomeren ist im Verhältnis dünn und ändert die Größe des Kautschukteilchens nicht wesentlich. Als Größe wird hier der $d_{50}$-Wert verstanden, d.h. der Durchmesser oberhalb dessen und unterhalb dessen jeweils 50 % der Durchmesser der Teilchen liegen. Die Pfropfreaktion ist unvollständig, so daß ihr Produkt als Pfropfprodukt bezeichnet wird. Neben dem eigentlichen Pfropfpolymerisat enthält es auch nichtgepfropfte Copolymere der Pfropfmonomeren.

Mann kann die Pfropfpolymerisate auch durch Masse/Lösung- oder Masse/Suspensionspolymerisation, vorzugsweise aus Monomer-löslichem Kautschuk herstellen. Die Größe der Pfropfkautschukteilchen wird dann in der Phaseninversionsstufe festgelegt und kann mechanisch (durch Rühren) und durch chemische Beeinflussung des Phasengleichgewichts (Zusatz von Dispergatoren) beeinflußt werden. Im allgemeinen werden bei Masse/Lösungs-Pfropfprozessen Teilchen von 1 μm Durchmesser oder größer erhalten. Der Kautschukgehalt des Pfropfproduktes ist auf maximal 25 Gew.-% beschränkt.

Man kann erfindungsgemäß Produkte verwenden, deren Teilchen eine Größe von 0,05 bis 20 μm haben und solche, in denen ein erheblicher Teil der Pfropfmonomeren im Innern der Kautschukteilchen als Homo- oder Copolymerisat inkludiert ist. Bevorzugte Teilchengrößen sind 0,05 bis 1,2 μm, insbesondere 0,05 bis 0,6 μm. Es ist auch möglich, mehrere verschiedene Pfropfprodukte nebeneinander einzusetzen z.B. zwei Pfropfprodukte, die sich durch den Pfropfgrad (oder durch die Pfropfdichte), die Teilchengröße oder durch beides gleichzeitig unterscheiden. Besonders geeignet ist beispielsweise ein Gemisch aus einem Pfropfprodukt mit Teilchen einer Größe $d_{50}$ von 0,35 und 10 μm und einem Pfropfprodukt mit Teilchen einer Größe $d_{50}$ von 0,05 bis 0,32 μm (so hergestellte ABS-Polymerisate werden auch als Bimodalysysteme bezeichnet).

Bevorzugt enthalten die Pfropfprodukte 35 bis 80 Gew.-%, insbesondere 40 bis 70 Gew.-%, Kautschuk und besitzen Teilchengrößen $d_{50}$ von 0,1 bis 0,5 μm. Sie werden in einer solchen Menge eingesetzt, daß das fertige ABS-Polymerisat 5 bis 25 Gew.-%, bevorzugt 5 bis 20 Gew.-%, Kautschuk enthält.

Das den zweiten Bestandteil des ABS-Polymerisats bildende thermoplastische Harz (b) stellt die durchgehende Matrix dar und ist ein Polymerisat oder Copolymerisat von Styrol, α-Methylstyrol/Acrylnitril/Methyl(meth)acrylat oder Maleinsäureanhydrid. Bevorzugt sind Polystyrol, Styrol-Acrylnitril-Copolymerisate mit einem Acrylnitrilgehalt von 20 bis 35 Gew.-% sowie Methylstyrol-Acrylnitril-Copolymerisate mit einem Acrylnitrilgehalt von 20 bis 31 Gew.-%. Das Gewichtsmittel des Molekulargewichtes ($\overline{M}_w$) dieser Harze ist 50 000 bis 550 000; die molekulare Uneinheitlichkeit U.

$$\left( \frac{\overline{M}_w}{\overline{M}_n} - 1 = U \right)$$

ist 1,0 - 3,5
($\overline{M}_n$ = Zahlenmittel des Molekulargewichts)

Verwendet man ein einzelnes Pfropfprodukt, so ist es vorteilhaft, wenn die quantitative Zusammensetzung der Pfropfmonomeren und die des Harzes ähnlich oder gleich sind. Verwendet man ein Gemisch von zwei Pfropfprodukten verschiedener Teilchengrößen, dann ist es vorteilhaft, wenn die quantitative Zusammensetzung der Pfropfmonomeren des Pfropfproduktes mit den gröberen Teilchen von der Zusammensetzung des Harzes verschieden ist.

Die thermoplastischen Harze, z.B. Styrol/Acrylnitril oder α-Methylstyrol/Acrylnitril-Copolymerisate können nach bekannten Verfahren hergestellt werden, z.B. durch Massepolymerisation, Lösungspolymerisation, Suspensionspolymerisation und Emulsionspolymerisation.

Pfropfprodukt und thermoplastisches Harz werden häufig getrennt hergestellt, beide meist durch Emulsionspolymerisation. Fallen die Komponenten in Latexform an, so können die Latices gemischt und gemeinsam ausgefällt werden.

Zur Herstellung der Kunststoffschicht geeignete thermoplastische Polystyrole sind Homopolymerisate des Styrols oder Mischpolymerisate des Styrols mit vorzugsweise Acrylnitril und/oder Butadien, und/oder Maleinsäureester, die z.B. durch Suspensionspolymerisation in Gegenwart von Katalysatoren aus den Monomeren bzw. der Mischung der Monomeren mit $\overline{M}w$ von 10 000 bis 600 000 erhalten werden ($\overline{M}w$ wird gemessen in DMF bei c = 5 g/l und 20° C). (Literatur dazu siehe: Beilsteins Handbuch der Organischen Chemie, 4, Auflage, 3. Ergänzungswerk, Bd. 5, Seiten 1163 - 1169, Springer Verlag 1964, H.Ohlinger, Polystyrol, 1. Teil, Herstellungsverfahren und Eigenschaften der Produkte, Springer Verlag 1955).

Die Einbringung der weiteren Kunststoffschicht erfolgt durch Hinterspritzen nach bekannten Verfahren, siehe dazu beispielsweise DE-A-27 55 088. Die Dicke der weiteren Kunststoffschicht liegt vorzugsweise zwischen 1 und 20 mm.

Die Vorteile der erfindungsgemäß verwendeten PU-Haftschichten sind ihr klebfreies Verhalten bei Raumtemperatur an der Oberfläche der Beschichtung, jedoch hervorragende Haftung zum Metall, ferner Ausbildung einer hervorragend haftenden, flexibel ausgleichend wirkenden Haftschicht bei der Schmelzekaschierung mit den thermoplastischen Kunststoffen ohne Versprödung, so daß auch beim Erkalten der Schmelzeschicht keine Abrisse oder partielle Ablösungen infolge der Scherkräfte auftreten.

Außerdem weisen die Polyurethane eine gegenüber sehr vielen (nicht nur gegenüber wenigen, ausgewählten Stoffen, wie Haftschichten nach dem Stand der Technik) thermoplastischen Stoffen verbesserte Haftung und Verträglichkeit auf.

## Beispiel 1

Eine 35 μm dicke Hartkupferfolie wird mit einer 30 %igen Polyurethandispersion auf Basis eines Polyesters aus aromatischer Dicarbonsäure und Alkylendiolen, Hexamethylendiisocyanat und einer Diaminosulfonsäure (Dispercoll® 8100 der Bayer AG, D-5090 Leverkusen) nach dem Rollcoater-Verfahren und Abtrocknen bei 75 bis 85° C zu einer 10 μm dicken Schicht des genannten Polyurethansystems einseitig vorbeschichtet. Diese vorbeschichtete Cu-Folie wird in den Walzenspalt einer Extrusionsbeschichtungsanlage einlaufen gelassen und mit der Schmelze eines Polycarbonats auf Basis Bisphenol A, dessen rel. Viskosität $\eta_{rel}$ bei 1,32 liegt (gemessen 0,5 %ig Methylenchlorid bei 23° C), beschichtet. Die Schichtdicke der aufgebrachten Polycarbonatschicht beträgt 100 μm.

Aus diesem Verbundlaminat wird nach an sich üblichen Methoden durch partielles Abätzen der Kupferfolie eine flexible gedruckte Verdrahtung hergestellt.

Die erhaltene flexible Verdrahtung wird in ein Spritzgußwerkzeug eingelegt und auf der Polycarbonatseite mit der Schmelze eines thermoplastischen ABS-Kunststoffes auf Basis Poly-Acrylnitril-Butadien-Styrol mit einer relativen Viskosität von 1,4 (gemessen 1 %ig in Aceton) hinterspritzt.

## Beispiel 2

Herstellung eines Verbundlaminates gemäß Beispiel 1, jedoch unter Verwendung einer Schmelze eines Polyphenylensulfids. Aus dem so hergestellten Verbund wird eine flexible Verdrahtung durch partielles Abätzen der Kupferschicht hergestellt. Diese flexible Verdrahtung wird, entsprechend der Gehäuseform eines elektronischen Gerätes, dreidimensional geformt. Anschließend erfolgt die Bestükkung mit elektronischen Bauteilen im SMD-Verfahren. Die bestückte dreidimensional gedruckte Verdrahtung wird in das vorgesehene Gehäuse eingelegt und an den Eckpunkten durch Kontaktkleber fixiert.

## Beispiel 3

Eine 35 μm dicke Hartkupferfolie wird mit einer etwa 30 %igen Lösung eines OH-endgruppenhaltigen Polyurethans auf Basis eines Adipinsäure-Butandiol-1,4/Hexandiol-1,6-Mischpolyesters und Hexamethylendiisocyanat (Desmocoll® 8303 der Bayer AG, D-5090 Leverkusen), gelöst in einem Ethylacetat/Methylethylketon-(1:1)-Gemisch, dem zur Vernetzung das Biurettriisocyanat des Hexamethylendiisocyanats (Desmodur® N der Bayer AG) in Mengen von 0, 0,5 bzw. 1, bzw. 3 Gew.-%, bezogen auf PU-Feststoff, zugesetzt wurde, nach dem Roll-Coater-Verfahren einseitig beschichtet und bei 80° C getrocknet. Die PU-Schicht hat eine Stärke von 18 μm.

Diese PU-beschichtete Cu-Folie wird jeweils wie in Beispiel 1 mit einer Schmelze von Polyphenylensulfid (PPS) in einer Schichtdicke von 75 μm einseitig beschichtet. Aus diesem Verbundlaminat wird eine flexible gedruckte Verdrahtung durch partielles Abätzen der Cu-Folie nach vorgegebenen Schaltungsmustern in üblicher Verfahrenstechnik hergestellt. Die erhaltene flexible Verdrahtung wird in ein Spritzgußwerkzeug eingelegt und auf der PPS-Folienseite mit der Schmelze von PPS bei einer Massetemperatur von etwa 360° C im PPS hinterspritzt.

Dieses Verbundteil kann mit elektrischen Bauteilen bestückt und durch ein Lötbad im Durchlaufverfahren kontaktiert werden. Derartige Verbundlaminate bzw. Schaltungsteile sind mechanischen und auch bei Einwirkung von Dämpfen sehr stabil und ergeben Schaltteile mit höchster Sicherheit gegen Kontaktausfälle.

## Patentansprüche

1. Verfahren zur Herstellung eines Metall-Kunststoff-Laminates auf Basis einer Metallfolie, einer PU-Schicht und einem Kunststofffilm, dadurch gekennzeichnet, daß man eine Metallfolie mit einem Polyurethan in gelöster oder dispergierter Form beschichtet, wobei wäßrige, zu transparenten Filmen auftrocknende Dispersionen von Polyesterurethanen, welche COOH- und/oder Sulfonsäuregruppen aufweisen oder zu transparenten Filmen auftrocknende Lösungen von Polyurethanen, welche ein höhermolekulares Polyisocyanat als Vernetzer enthalten, eingesetzt werden, die flüssige Phase abzieht und das so erhaltene Polyurethanbeschichtete Teil mit einer Polyurethan-Trockenfilmstärke von 1-80 μm und klebfreier Oberfläche bei Raumtemperatur mit der Schmelze eines thermoplastischen Kunststoffes im Extrusionsbeschichtungsverfahren beschichtet.

2. Verfahren nach Anspruch 1, dadurch gekennzeichnet. daß das Metall eine Folie mit einer Schichtdicke von 0,01 bis 0,5 mm ist die PU-Schicht Trockenfilmstärken von 10 bis 30 μm aufweist.

3. Verfahren nach Anspruch 1 und 2, dadurch gekennzeichnet, daß als Polyurethankomponente ein Polyurethandispersionssystem auf Basis eines linearen Polyesterurethans. vorzugsweise auf Basis Polyalkylenadipinat oder zugsweise auf Basis Polyalkylenadipinat oder Polyalkylenphthalat mit einem Molekulargewicht von 1000 bis 8000 vorzugsweise von etwa 2000, einem Diisocyanat, vorzugsweise Toluylendiisocyanat oder Hexamethylendiisocyanat und carbonsäure-oder sulfonsäurehaltigen Diaminen, gegebenenfalls im Gemisch mit weiteren (cyclo)aliphatischen Diaminen. verwendet wird.

4. Verfahren nach Ansprüchen 1 und 2, dadurch gekennzeichnet, daß als Polyurethankomponente eine Polyurethanlösung auf Basis Polyesteradipinaten. vorzugsweise Polybutylenadipinat oder Polybutylenhexylenadipinat , mit einem Molekulargewicht von 1000 bis 8000 und Hexamethylendiisocyanat, gegebenenfalls in Mischung mit Isophorondiisocyanat im Verhältnis 1-99:99-1 und gegebenenfalls Diol-Kettenverlängerungsmittel und/oder Isophorondiamin. verwendet wird.

5. Verfahren nach Ansprüchen 1,2 und 4, dadurch gekennzeichnet. daß als Polyurethan eine vorzugsweise OH-Endgruppen aufweisende Polyetherurethanlösung eingesetzt wird, die mit Triisocyanaten oder Polyisocyanaten vernetzt wird.

6. Verfahren nach Ansprüchen 1-5, dadurch gekennzeichnet, daß als thermoplastische Kunststoffe solche auf Basis von Celluloseester, PVC, Polyamid, Polycarbonat, Polyulfon, ABS, Polymethylmethacrylat, Polyphenylensulfid, Polyalkylenterephthalat, Polyarylenterephthalat, Polyphenylenoxid, Polyphosphonat und Polyetheresterketon verwendet werden.

7. Verfahren nach Ansprüchen 1 bis 6, dadurch gekennzeichnet, daß das Metallteil des nach Anspruch 1 erhaltenen Verbundlaminates zur Herstellung einer elektrischen Schaltung partiell abgeätzt wird, gegebenenfalls die so erhaltene Schaltung nach dem Abätzen dreidimensional verformt und gegebenenfalls mit einem weiteren thermoplastischen Kunststoff hinterspritzt wird.

8. Verfahren nach Anspruch 7, dadurch gekennzeichnet, daß zum Hinterspritzen einer der in Anspruch 6 angegebenen thermoplastischen Kunststoffe verwendet wird.

## Claims

1. A process for the production of a metal/plastic laminate based on a metal foil, a PU layer and a plastic film, characterized in that a metal foil is coated with a dissolved or dispersed polyurethane using aqueous dispersions of polyester urethanes containing COOH and/or sulfonic acid groups, which dry to form transparent films, or solutions of polyurethanes containing a relatively high molecular weight polyisocyanate as crosslinking agent, which dry to form transparent films, the liquid phase is removed and the polyurethane-coated part thus obtained, which has a polyurethane dry film thickness of 1 - 80 $\mu$m and a tack-free surface, is extrusion-coated at room temperature with a melt of a thermoplastic.

2. A process as claimed in claim 1, characterized in that the metal is a foil having a layer thickness of 0.01 to 0.5 mm and in that the PU layer has dry film thicknesses of 10 to 30 $\mu$m.

3. A process as claimed in claims 1 and 2, characterized in that a polyurethane dispersion system based on a linear polyester urethane and preferably based on polyalkylene adipate or polyalkylene phthalate having a molecular weight of 1,000 to 8,000 and preferably of the order of 2,000, a diisocyanate, preferably tolylene diisocyanate or hexamethylene diisocyanate, and diamines containing carboxylic or sulfonic acids, optionally in admixture with other (cyclo)aliphatic diamines, is used.

4. A process as claimed in claims 1 and 2, characterized in that a polyurethane solution based on polyester adipates, preferably polybutylene adipate or polybutylene hexylene adipate, having a molecular weight of 1,000 to 8,000 and hexamethylene diisocyanate, optionally in admixture with isophorone diisocyanate in a ratio of 1-99:99-1, and optionally diol chain-extending agents and/or isophorone diamine is used.

5. A process as claimed in claims 1, 2 and 4, characterized in that a preferably OH-terminated polyether urethane solution crosslinked with triisocyanates or polyisocyanates is used.

6. A process as claimed in claims 1 to 5, characterized in that the thermoplastics used are thermoplastics based on cellulose ester, PVC, polyamide, polycarbonate, polysulfone, ABS, polymethyl methacrylate, polyphenylene sulfide, polyalkylene terephthalate, polyarylene terephthalate, polyphenylene oxide, polyphosphonate or polyether ester ketone.

7. A process as claimed in claims 1 to 6, characterized in that, to make an electrical circuit, the metal component of the laminate obtained by the process claimed in claim 1 is partly etched, the circuit obtained is optionally subjected to three-dimensional shaping after etching and is optionally back-extruded with another thermoplastic.

8. A process as claimed in claim 7, characterized in that one of the thermoplastics mentioned in claim 6 is used for back-extrusion.

## Revendications

1. Procédé de production d'un stratifié métalmatière plastique à base d'une feuille métallique, d'une couche de PU et d'une pellicule en matière plastique, caractérisé en ce qu'on enduit une feuille métallique d'un polyuréthanne sous la forme dissoute ou dispersée, en utilisant des dispersions aqueuses, séchant en formant des films transparents, de polyesteruréthannes qui portent des groupes COOH et/ou acide sulfonique, ou des solutions de polyuréthannes séchant en formant des films transparents, qui contiennent comme agents de réticulation un polyisocyanate de poids moléculaire élevé, on soutire la phase liquide et on revêt la partie enduite de polyuréthanne ainsi obtenue avec une épaisseur de film de polyuréthanne à l'état sec de 1 à 80 $\mu$m et une surface non collante, en opérant à la température ambiante, de la masse fondue d'une matièe thermoplastique par le procédé de revêtement par extrusion.

2. Procédé suivant la revendication 1, caractérisé en ce que le métal est une feuille ayant une épaisseur de couche de 0,01 à 0,5 mm, et la couche de polyuréthanne présente des épaisseurs de film à l'état sec de 10 à 30 $\mu$m.

3. Procédé suivant les revendications 1 et 2, caractérisé en ce qu'on utilise comme composant polyuréthanne un système de dispersion de polyuréthanne à base d'un polyester-uréthanne linéaire, de préférence à base de polyalkylène-adipate ou de polyalkylènephtalate ayant un poids moléculaire de 1000 à 8000, de préférence d'environ 2000, avec un diisocyanate, de préférence un diisocyanatotoluène ou l'hexaméthylènediisocyanate et des diamines contenant un acide carboxylique ou un acide sulfonique, le cas échéant en mélange avec d'autres diamines (cyclo)aliphatiques.

4. Procédé suivant les revendications 1 et 2, caractérisé en ce qu'on utilise comme composant polyuréthanne une solution de polyuréthanne à base de polyester-adipates, de préférence de polybutylène-adipate ou de polybutylènehexylène-adipate, avec un poids moléculaire de 1000 à 8000 et l'hexaméthylènediisocyanate, le cas échéant en mélange avec l'isophoronediisocyanate dans le rapport de 1-99:99-1 et, éventuellement, des agents d'allongement de chaîne du type de diols et/ou l'isophoronediamine.

5. Procédé suivant les revendications 1, 2 et 4, caractérisé en ce qu'on utilise comme polyuréthanne une solution de polyéther-uréthanne portant de préférence des groupes terminaux OH, qui est réticulée avec des triisocyanates ou des polyisocyanates.

6. Procédé suivant les revendications 1 à 5, caractérisé en ce qu'on utilise comme matière thermoplastiques, des matières à base d'esters de cellulose, de PVC, de polyamide, de polycarbonate, de polysulfone, d'ABS, de polyméthacrylate de méthyle, de polyphénylènesulfure , de polyalkylènetéréphtalate, de polyarylènetéréphtalate, de polyphénylène-oxyde, de polyphosphonate et de polyétherestercétone.

7. Procédé suivant les revendications 1 à 6, caractérisé en ce que la partie métallique du stratifié composite obtenu selon la revendication 1 est partiellement corrodée pour l'établissement d'un circuit électrique, le circuit ainsi obtenu est éventuellement soumis à une déformation tridimensionnelle après la corrosion et une autre matière thermoplastique est éventuellement moulée par injection au revers.

8. Procédé suivant la revendication 7, caractérisé en ce qu'on utilise pour le moulage par injection au revers l'une des matières thermoplastiques indiquées dans la revendication 6.